# EUROPÄISCHE PATENTSCHRIFT

(11) **EP 0 358 885 B1**
(45) Veröffentlichungstag und Bekanntmachung des Hinweises auf die Patenterteilung: **20.10.1993**
(21) Anmeldenummer: 89113027.0
(22) Anmeldetag: 15.07.1989
(51) Int. Cl.: H05F 3/00, H01H 13/70, G09F 9/33

(54) **Abdeckmatte für Schaltungsträger**
Cover membrane for a circuit carrier
Membrane de recouvrement pour plaquette de circuit

(30) Priorität: 15.09.1988 DE 3831314
(43) Veröffentlichungstag der Anmeldung: 21.03.1990
(73) Patentinhaber: HAGENUK GMBH, D-24118 Kiel (DE)
(72) Erfinder: Heise, Jens, D-2370 Rendsburg (DE)
(74) Vertreter: Hansmann, Dierk, Dipl.-Ing.

(56) Entgegenhaltungen:
- DE-A- 3 346 896
- FR-A- 2 517 846

## Beschreibung

Die Erfindung bezieht sich auf eine Abdeckmatte für einen Schaltungsträger in Form einer Leiterplatte mit vorstehenden Bauelementen als Anzeigeelemente, insbesondere LED-Elemente, aus elektrisch isolierendem Kunststoff zu Erhöhung der ESD-Festigkeit, wobei der Leiterplatte unter Ausbildung eines Zwischenraumes für die Aufnahme der Abdeckmatte eine Bedienungsplatte eines Gerätes, wie Fernsprechgerätes, zugeordnet ist, und bei der Ausprägungen im Bereich der Anzeigeelmente als Aufnahmedome ausgebildet sind.

Es ist bekannt, in der Fermeldetechnik Abdeckmatten einzusetzen, um die Bestimmungen zur ESD-Festigkeit zu erfüllen. ESD heißt Electrostatic Discharge und bedeutet, daß die Störfestigkeit gegen Entladung statischer Spannungen nachgewiesen werden muß.

In der Praxis hat sich gezeigt, daß es mit großem Aufwand verbunden ist, diese Störfestigkeit zu gewährleisten, wenn gleichzeitig die Forderung besteht, Leuchtpunkte der Anzeigeelemente möglichst dicht an die Bedienoberfläche zu bringen.

Aus der DE-A-33 46 896 ist es bekannt, zur Gewährleistung eines ausreichenden Schutzes gegenüber von elektrostatischen Entladungen eine Isolationsfolie zu verwenden, die zwischen Leuchtdioden und einer Bedienungsplatte angeordnet ist. Die Folie umschließt kuppelförmig die Leuchtdiode und ragt gemeinsam mit den Leuchtdioden in Ausnehmungen hinein, die im Bereich der Bedienungsplatte angeordnet sind. Die Leuchtdiode erstreckt sich gemeinsam mit der Isolationsfolie durch die Ausnehmung hindurch bis unmittelbar in den Bereich der Oberfläche der Bedienungsplatte. Zwischen der Isolationsfolie und einer Leiterplatte ist ein Abstand vorgesehen.

Die Aufgabe der Erfindung ist es, mit geringem Aufwand eine ESD-Festigkeit bei einer gattungsgemäßen Anordnung zu schaffen und dabei den Leuchtpunkt der Anzeigeelemente nahe an die Bedienoberfläche zu bringen sowie eine ausreichende Wegstrecke zwischen Auftreffpunkt und gefährdetem Bauteil zu gewährleisten.

Die Lösung dieser Aufgabe erfolgt erfindungsgemäß dadurch, daß die Aufnahmedome im oberen Endbereich jeweils eine Materialanhäufung in der Art einer Noppe als Leuchtpunktverlängerung aufweisen, daß die Noppen in zugeordnete Ausnehmungen der Bedienungsplatte einsetzbar sind und daß die Noppe gegenüber dem Aufnahmedom abgesetzt ist und eine vorbestimmte Form, wie z.B. eine Dreiecks oder Vierecksform aufweist.

Der Vorteil dieser Ausbildung besteht darin, daß mit einfachen Mitteln die Bedingungen der ESD-Festigkeit erfüllt werden und gleichzeitig die Montage vereinfacht wird, da die Anzeigeelemente auf der Leiterplatte nicht auszurichten sind und über die eingesetzten Noppen in die zugeordneten Durchtritte der Bedientafel ein Toleranzausgleich ermöglicht wird. Hierdurch wird auch eine erhebliche Montagevereinfachung geschaffen.

Insbesondere ist vorgesehen, daß die Noppe gegenüber dem Aufnahmedom abgesetzt ist und eine Dreiecks-, Vierecksform oder dergleichen aufweist.

Zur guten Lichtleitung in dem Bereich der Bedienoberfläche wird vorgeschlagen, daß ein blasenfreier, durchsichtiger Kunststoff aus Silikon-Kautschuk als Material verwendet wird.

Weiterhin wird vorgeschlagen, daß dem Aufnahmedom für das Anzeigeelement ein Tastendom für ein Betätigungselement parallel zugeordnet ist.

Eine erfindungsgemäße Ausführungsform ist in der Zeichnung schematisch dargestellt. Es zeigen:

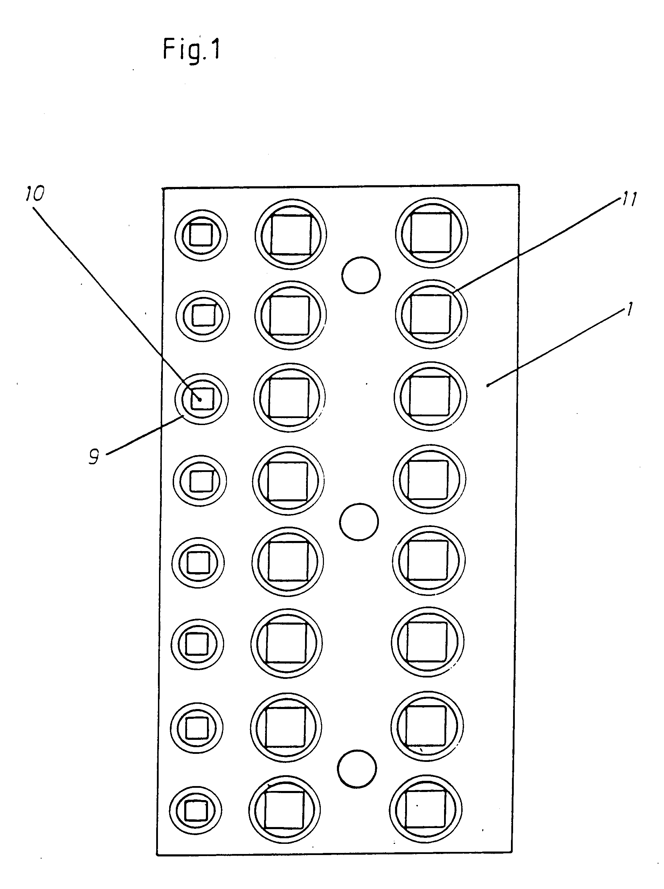

- Fig. 1: eine Draufsicht auf eine Schaltmatte in vergrößerter Darstellung,

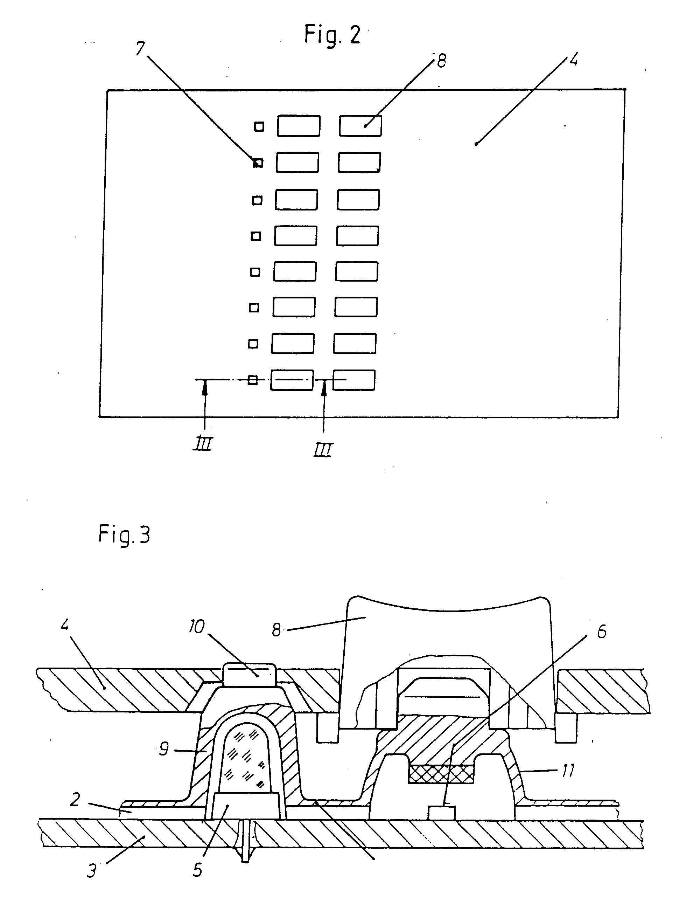

- Fig. 2: eine Draufsicht einer Bedientafel mit Durch-Betätigungselementen und
- Fig. 3: einen Teilschnitt gemäß Linie III-III der Fig. 2.

Bei der dargestellten Ausbildung ist eine flexible Abdeckmatte 1 aus Silikon-Kautschuk unter Ausbildung von Lüftungskanaälten 2 zwischen einer Leiterplatte 3 und einer Bedienplatte 4 zur Erzielung einer erforderlichen ESD-Festigkeit angeordnet.

Auf der Leiterplatte 3 sind Anzeigeelemente als LED-Elemente 5 und in diesem Fall auch Schaltelemente 6 eingesetzt. In der zugeordneten Bedienplatte 4 befinden sich Durchtritte 7 und etätigungselemente 8 entsprechend der Schaltelemente 6.

Die Abdeckmatte 1 besitzt im Bereich der LED-Elemente 5 Ausprägungen als Aufnahmedome 9, die im oberen Endbereich jeweils eine Noppe 10 durch eine Materialanhäufung bilden und als Leuchtpunktverlängerung dienen. Die jeweilige Noppe 10 ist bei der Montage in dem zugeordneten Durchtritt 7 der Bedienplatte 4 festsetzbar.

In dieser Ausbildung besitzt die Abdeckmatte 1 zusätzlich Tastendome 11, die den Schaltelementen 6 der Bedienplatte 4 zugeordnet sind.

## Patentansprüche

1. Abdeckmatte für einen Schaltungsträger in Form einer Leiterplatte mit vorstehenden Bauelementen als Anzeigelemente, insbesondere LED-Elemente, aus elektrisch isolierendem Kunststoff zur Erhöhung der ESD-Festigkeit, wobei der Leiterplatte unter Ausbildung eines Zwischenraumes für die Aufnahme der Abdeckmatte eine Bedienungsplatte eines Gerätes, wie Fernsprechgerätes, zugeordnet ist, und bei der Ausprägungen im Bereich der Anzeigeelemente (5) als Aufnahmedome (9) ausgebildet sind, dadurch gekennzeichnet, daß die Aufnahmedome (9) im oberen Endbereich jeweils eine Materialanhäufung in der Art einer Noppe (10) als Leuchtpunktverlängerung aufweisen, daß die Noppen (10) in zugeordnete Ausnehmungen (7) der Bedienungsplatte (4) einsetzbar sind und daß die Noppe (10) gegenüber dem Aufnahmedom (9) abgesetzt ist und eine vorbestimmte Form, wie z.B. eine Dreiecks oder Vierecksform aufweist.

2. Abdeckmatte nach Anspruch 1, dadurch gekennzeichnet, daß ein blasenfreier, durchsichtiger Kunsstoff aus Silikon-Kautschuk als Material verwendet wird.

3. Abdeckmatte nach Anspruch 1 oder 2, dadurch gekennzeichnet, daß dem Aufnahmedom (9) für das Anzeigeelement (5) ein Tastendom (11) für ein Betätigungselement (8) parallel zugeordnet ist.

## Claims

1. A covering mat for a circuit carrier in the form of a printed circuit board with projecting components as display elements, in particular LED- elements, composed of electrically insulating synthetic resin to increase the resistance to electrostatic discharge, wherein a control panel of a device, such as a telephone device, is assigned to the circuit board forming an interspace for the accommodation of the covering mat, and wherein embossments in the region of the display elements (5) have the form of receiving domes (9), characterised in that the receiving domes (9) in the upper end zone each comprise a material accumulation in the form of a protuberance (10) as light spot extension, that the protuberances (10) can be inserted into assigned recesses (7) of the control panel (4), and that the protuberance (10) is offset relative to the receiving dome (9) and has a predetermined shape, such as for example a triangular or quadrangular shape.

2. A covering mat as claimed in Claim 1, characterised in that a void-free, transparent synthetic resin made of silicon rubber is used as material.

3. A covering mat as claimed in Claim 1 or 2, characterised in that a key dome (11) for an actuating element (8) is assigned in parallel to the receiving dome (9) for the display element (5).

## Revendications

1. Nappe de couverture pour un support de montage sous forme de plaque à circuit imprimé portant des éléments constitutifs en saillie, tels que des éléments indicateurs, en particulier des éléments LED, nappe de couverture faite de matière synthétique isolante de l'électricité pour l'augmentation de la résistance ESD, une plaque de commande d'un appareil, tel qu'un appareil téléphonique, étant adjointe à la plaque de circuit imprimé à la distance d'un intervalle destiné à contenir la nappe de couverture, dans laquelle il a été formé des empreintes constituant des bossages de réception (9) dans la zone des éléments indicateurs (5), la nappe de couverture étant caractérisée en ce que les bossages de réception (9) comportent chacun, en leur partie d'extrémité supérieure, un amassement de matière se présentant comme un bouton (10) qui constitue le prolongement du point lumineux, en ce que les boutons (10) peuvent se placer dans les ouvertures correspondantes (7) de la plaque de commande (4), et en ce que le bouton (10) forme un décalage ou degré par rapport au bossage de réception (9) et se présente sous une forme déterminée au préalable, telle que, par exemple, une forme triangulaire ou une forme quadrangulaire.

2. Nappe de couverture suivant la revendication 1, caractérisée en ce qu'il est utilisé comme matière une matière synthétique transparente exempte de "soufflures", faite de caoutchouc-silicone.

3. Nappe de couverture suivant l'une ou l'autre des revendications 1 et 2, caractérisée en ce qu'au bossage de réception (9) pour l'élément indicateur (5), il est adjoint en parallèle un bossage à touche (11) pour un élément d'actionnement (8).
